# EUROPEAN PATENT SPECIFICATION

(11) **EP 1 131 612 B1**
(45) Date of publication and mention of the grant of the patent: **17.05.2006**
(21) Application number: 98941892.6
(22) Date of filing: 31.08.1998
(51) Int. Cl.: G01J 5/20, H01L 31/0248

(54) **BOLOMETER INCLUDING AN ABSORBER MADE OF A MATERIAL HAVING A LOW DEPOSITION-TEMPERATURE AND A LOW HEAT-CONDUCTIVITY**
BOLOMETER MIT EINER ABSORPTIONSSCHICHT AUS EINEM MATERIAL MIT EINER NIEDRIGEN ABLAGERUNGSTEMPERATUR UND EINER GERINGEN WÄRMELEITFÄHIGKEIT
BOLOMETRE COMPRENANT UN ABSORBEUR REALISE DANS UN MATERIAU A FAIBLE TEMPERATURE DE DEPOT ET A FAIBLE CONDUCTIVITE THERMIQUE

(43) Date of publication of application: 12.09.2001
(73) Proprietor: Daewoo Electronics Corporation, Seoul (KR)
(72) Inventor: JU, S. Video Res. Ctr., Daewoo Electr Co., Ltd., Jung-Gu Seoul 100-095 (KR); YONG, Y. Video Res. Ctr., Daewoo Electr. Co., Ltd., Jung-Gu Seoul 100-095 (KR)
(74) Representative: Jacoby, Georg
(86) International application number: PCT/KR1998/000266
(87) International publication number: WO 2000/012985

(56) References cited:
- EP-A1- 0 534 768
- US-A- 5 572 029

## Description

### TECHNICAL FIELD OF THE INVENTION

The present invention relates to an infra-red bolometer; and, more particularly, to a three-level infra-red bolometer including an absorber made of a material having a low deposition-temperature and a low heat-conductivity.

### BACKGROUND ART

Bolometers are energy detectors based upon a change in the resistance of materials (called bolometer elements) that are exposed to a radiation flux. The bolometer elements have been made from both metals and semiconductors. In case of the metals, the resistance change is essentially due to a variation in the carrier mobility, which typically decreases with temperature. In contrast, greater sensitivity can be obtained in high-resistivity semiconductor bolometer elements wherein the free-carrier density is an exponential function of temperature; however, thin film fabrication of semiconductor elements for the construction of bolometers is a difficult task.

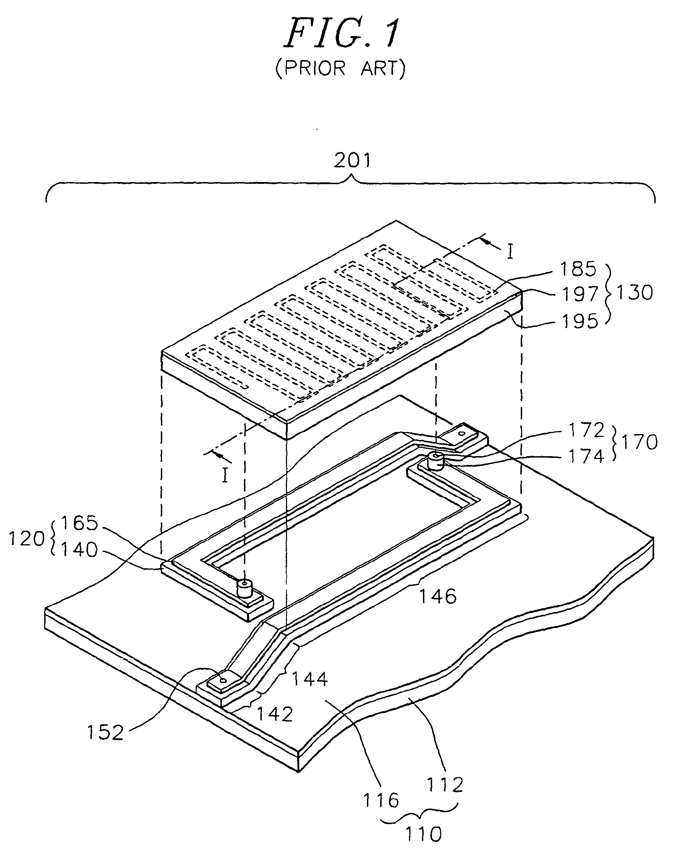

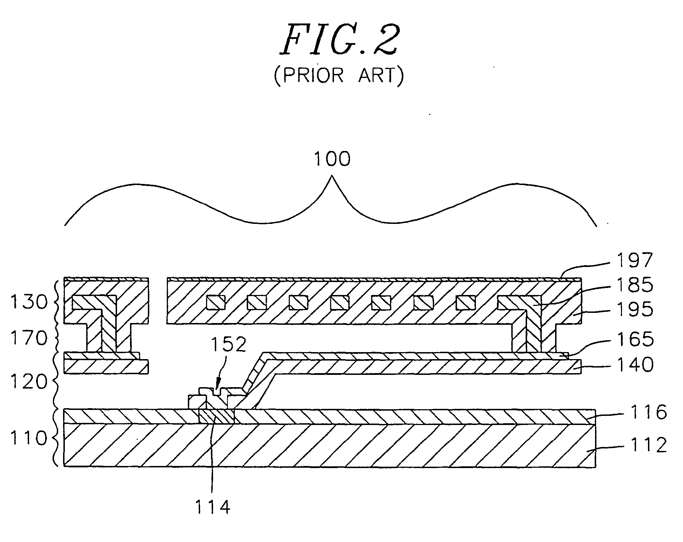

In Figs. 1 and 2, there are shown a perspective view and a cross sectional view illustrating a three-level bolometer 100, disclosed in WO-A-0003214, published after the filing date of the present application. The bolometer 100 comprises an active matrix level 110, a support level 120, at least a pair of posts 170 and an absorption level 130.

The active matrix level 110 has a substrate 112 including an integrated circuit (not shown), a pair of connecting terminals 114 and a protective layer 116. Each of the connecting terminals 114 made of a metal is located on top of the substrate 112. The protective layer 116 made of, e.g., silicon nitride (SiNₓ), covers the substrate 112. The pair of connecting terminals 114 are electrically connected to the integrated circuit.

The support level 120 includes a pair of bridges 140 made of silicon nitride (SiNₓ), each of the bridges 140 having a conduction line 165 formed on top thereof. Each of the bridges 140 is provided with an anchor portion 142, a leg portion 144 and an elevated portion 146, the anchor portion 142 including a via hole 152 through which one end of the conduction line 165 is electrically connected to the connecting terminal 114, the leg portion 144 supporting the elevated portion 146.

The absorption level 130 is provided with a serpentine bolometer element 185 made of titanium (Ti), an absorber 195 made of silicon nitride (SiNₓ) and an IR absorber coating 197 formed on top of the absorber 195. The absorber 195 is fabricated by depositing silicon nitride before and after the formation of the serpentine bolometer element 185 to surround the serpentine bolometer element 185.

Each of the posts 170 is placed between the absorption level 130 and the support level 120. Each of the posts 170 includes an electrical conduit 172 made of a metal, e.g., titanium (Ti), and surrounded by an insulating material 174 made of, e.g., silicon nitride (SiNₓ). Top end of the electrical conduit 172 is electrically connected to one end of the serpentine bolometer element 185 and bottom end of the electrical conduit 172 is electrically connected to the conduction line 165 on the bridge 140, in such a way that both ends of the serpentine bolometer element 185 in the absorption level 130 is electrically connected to the integrated circuit of the active matrix level 110 through the electrical conduits 172, the conduction lines 165 and the connecting terminals 114. When exposed to infra-red radiation, the resistivity of the serpentine bolometer element 185 changes, causing a current and a voltage to vary, accordingly. The varied current or voltage is amplified by the integrated circuit, in such a way that the amplified current or voltage is read out by a detective circuit (not shown).

There are certain deficiencies associated with the above described three-level bolometer 100. When selecting the material for the absorber 195, it is important to consider the fabrication conditions, e.g., deposition-temperature, and the material characteristics, e.g., heat-conductivity. In the above described three-level bolometer 100, since silicon nitride (SiNₓ) can be formed only at a relatively high temperature, e.g., over 850 °C, titanium (Ti) constituting the serpentine bolometer element 185 gets easily oxidized during the formation of the absorber 195, which will, in turn, detrimentally affect the temperature coefficient of resistance (TCR) thereof. Further, silicon nitride (SiNₓ) has a relatively high heat-conductivity, reducing the thermal isolation effect of the absorber 195 in the bolometer 100.

### DISCLOSURE OF THE INVENTION

It is, therefore, a primary object of the present invention to provide a three-level infra-red bolometer including an absorber made of a material that can be formed at a low temperature and has a low heat-conductivity.

In accordance with one aspect of the present invention, there is provided a three-level infra-red bolometer, which comprises: an active matrix level including a substrate and at least a pair of connecting terminals; a support level provided with at least a pair of bridges, each of the bridges including an conduction line, one end of the conduction line being electrically connected to the respective connecting terminal; an absorption level including a bolometer element formed between an upper absorber and a lower absorber, the absorbers being made of silicon oxide or silicon oxy-nitride; and at least a pair of posts, each of the posts being placed between the absorption level and the support level and including an electrical conduit surrounded by an insulating material, each end of the bolometer element of the absorption level being electrically connected to the respective connecting terminal through the respective electrical conduit and the respective conduction line.

### BRIEF DESCRIPTION OF THE DRAWINGS

The above and other objects and features of the present invention will become apparent from the following description of the preferred embodiments given in conjunction with the accompanying drawings, wherein:
Fig. 1 shows a perspective view setting forth an infra-red bolometer previous disclosed;
Fig. 2 present a schematic cross sectional view depicting the infra-red bolometer shown in Fig. 1;
Fig. 3 depicts a schematic cross sectional view setting forth a three-level infra-red bolometer in accordance with the present invention; and
Figs. 4A to 4B provide schematic cross sectional views depicting an absorption level in accordance with two preferred embodiments of present invention, respectively.

### MODES OF CARRYING OUT THE INVENTION

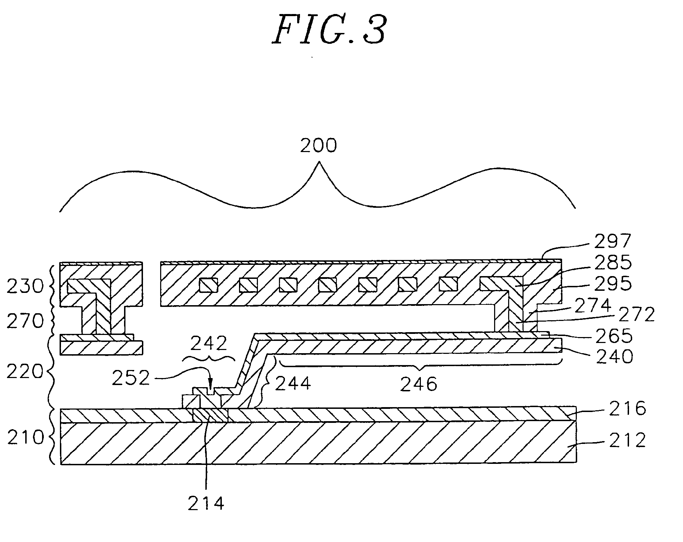

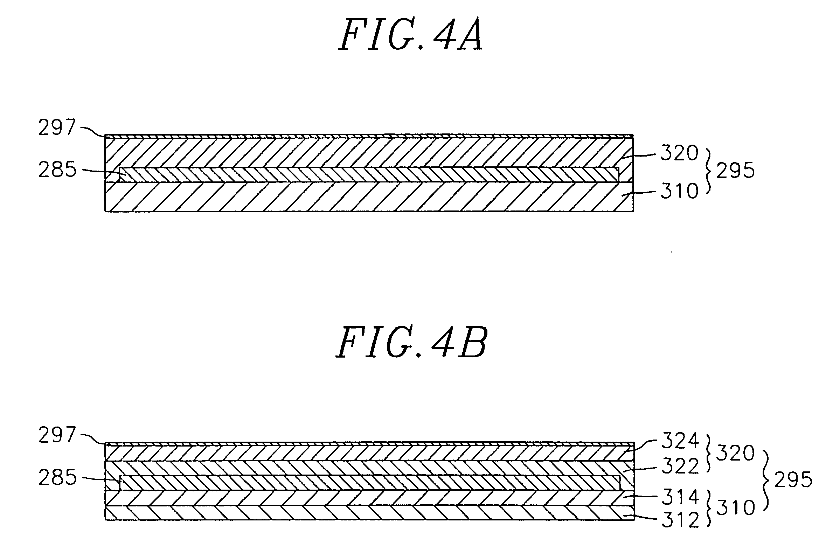

There are provided in Figs. 3 and 4A to 4B a schematic cross sectional view setting forth a three-level infra-red bolometer 200 and schematic cross sectional views of an absorption level therein in accordance with two embodiments of the present invention, respectively. It should be noted that like parts appearing in Figs. 3 and 4A to 4B are represented by like reference numerals.

The inventive bolometer 200 shown in Fig. 3 comprises an active matrix level 210, a support level 220, at least a pair of posts 270 and an absorption level 230.

The active matrix level 210 has a substrate 212 including an integrated circuit (not shown), a pair of connecting terminals 214 and a protective layer 216. Each of the connecting terminals 214 made of a metal is located on top of the substrate 212. The pair of connecting terminals 214 are electrically connected to the integrated circuit. The protective layer 216 made of, e.g., silicon nitride (SiNₓ) covers the substrate 212.

The support level 220 includes a pair of bridges 240 made of an insulating material, e.g., silicon oxide (SiO₂) or silicon oxy-nitride (SiOₓN_{y}), each of the bridges 240 having a conduction line 265 formed on top thereof. Each of the bridges 240 is provided with an anchor portion 242, a leg portion 244 and an elevated portion 246, the anchor portion 242 including a via hole 252 through which one end of the conduction line 265 is electrically connected to the connecting terminal 214, the leg portion 244 supporting the elevated portion 246.

The absorption level 230 is provided with an absorber 295 made of an insulating material, a serpentine bolometer element 285 made of a metal, e.g., titanium (Ti), and an IR absorber coating 297 positioned on top of the absorber 295.

The table below provides the deposition-temperature and heat-conductivity for the materials that can be used as the material for the absorber 295.

| material | deposition-temperature (°C) | heat-conductivity (W/meter·°C) |
|---|---|---|
| SiNₓ | 850 | 19 |
| SiO₂ | 200 | 1.3 - 1.8 |
| SiOₓN_{y} | 300 | 10.1 - 10.4 |

As shown in the above table, silicon oxide (SiO₂) and silicon oxy-nitride (SiOₓN_{y}), respectively, has a lower heat-conductivity and a deposition-temperature than those for silicon nitride (SiNₓ).

In the first embodiment of present invention, the absorber 295 includes a lower part 310 and an upper part 320 which are made of an insulating material, e.g., silicon oxide (SiO₂) or silicon oxy-nitride (SiOₓN_{y}), as shown in Figs. 4A.

As shown in Fig. 4B, a second embodiment is similar to the first embodiment, except that an upper and a lower parts 310, 320 consist of two layers. The lower part 310 includes a first lower portion 312 made of silicon oxy-nitride (SiOₓN_{y}) and a second lower portion 314 made of silicon oxide (SiO₂). The upper part 320 includes a first upper portion 322 made of silicon oxide (SiO₂) and a second upper portion 324 made of silicon oxy-nitride (SiOₓN_{y}).

Each of the posts 270 is placed between the absorption level 230 and the support level 220. Each of the post 270 includes an electrical conduit 272 made of a metal, e.g., titanium (Ti) and surrounded by an insulating material 274 made of, e.g., silicon nitride (SiNₓ). Top end of the electrical conduit 272 is electrically connected to one end of the serpentine bolometer element 285 and bottom end of the electrical conduit 272 is electrically connected to the conduction line 265 on the bridge 240, in such a way that both ends of the serpentine bolometer element 285 in the absorption level 230 is electrically connected to the integrated circuit of the active matrix level 210 through the electrical conduits 272, the conduction lines 265 and the connecting terminals 214. When the infra-red energy is absorbed, the resistivity of the serpentine bolometer element 285 is increased, in such a way that the increased resistivity is read out by a detective circuit (not shown).

In the three-level infra-red bolometer 200 of the present invention, the absorber 295 is made of a material having a relatively low heat conductivity and low deposition temperature, e.g., silicon oxide (SiO₂) or silicon oxy-nitride (SiOxNy). The low deposition temperature will prevent the bolometer element from getting oxidized during the formation thereof and the low conductivity will increase the thermal isolation effect of the absorber 295, which will, in turn, facilitate in ensuring an optimum performance of the bolometer 200, e.g., a responsivity, a detectivity and a noise equilibrium temperature difference (NETD).

While the present invention has been described with respect to certain preferred embodiments only, other modifications and variations may be made without departing from the scope of the present invention as set forth in the following claims.

## Claims

1. A three-level infra-red bolometer comprising:
an active matrix level (210) including a substrate (212) and at least a pair of connecting terminals (214);
a support level (220) provided with at least a pair of bridges (240), each of the bridges including a conduction line (265), one end of the conduction line being electrically connected to the respective connecting terminal;
an absorption level (230) including an absorber (295) having an upper (320) and a lower (310) parts and a bolometer element; and
at least a pair of posts (270), each of the posts being placed between the absorption level (230) and the support level (220) and including an electrical conduit (272) surrounded by an insulating material (274), each end of the bolometer element of the absorption level being electrically connected to the respective connecting terminal through the respective electrical conduit and the respective conduction line.

2. The bolometer of claim 1, wherein the absorption level (230) further includes an IR absorption coating (297).

3. The bolometer of claim 1, wherein the bolometer element is made of a metal.

4. The bolometer of claim 3, wherein the bolometer element is made of titanium (Ti).

5. The bolometer of claim 1, wherein the upper and the lower parts are made of a same material.

6. The bolometer of claim 5, wherein the material is silicon oxide (SiO₂).

7. The bolometer of claim 5, wherein the material is silicon oxy-nitride (SiOₓN_{y}).

8. The bolometer of claim 4, wherein the upper part and the lower part consist of two layers, respectively.

9. The bolometer of claim 8, wherein the lower part includes a first lower portion made of SiOₓN_{y} and a second lower portion made of SiO₂, and the upper part includes a first upper portion made of SiO₂ and a second upper portion made of SiOₓN_{y}.

10. The bolometer of claim 1, wherein the bridges are made of SiO₂ or SiOₓN_{y}.

11. A three-level infra-red bolometer according to claim 1, wherein the bolometer element is surrounded by an absorber made of silicon oxide (SiO₂).

12. The bolometer of claim 11, wherein the bridges are made of SiO₂.

13. The bolometer of claim 11, wherein the absorption level further includes an IR absorption coating.

14. A three-level infra-red bolometer according to claim 1, wherein the bolometer element is surrounded by an absorber made of silicon oxy-nitride (SiOₓN_{y}).

15. The bolometer of claim 14, wherein the bridges are made of SiOₓN_{y}.

16. The bolometer of claim 14, wherein the absorption level further includes an IR absorption coating.

17. A three-level infra-red bolometer according to claim 1, wherein
the absorption level includes an upper absorber, a lower absorber and a bolometer element formed between the upper and the lower parts, wherein the lower part includes a first lower portion made of SiOₓN_{y} and a second lower portion made of SiO₂, and the upper part includes a first upper portion made of SiO₂ and a second upper portion made of SiOₓN_{y}.

18. The bolometer of claim 17, wherein the bridges are made of SiO₂ or SiOₓN_{y}.

19. The bolometer of claim 17, wherein the absorption level further includes an IR absorption coating.

## Patentansprüche

1. Dreistufiges Infrarot-Bolometer mit:
einer Aktivmatrixstufe (210), die ein Substrat (212) und wenigstens ein Paar Verbindungsanschlüsse (214) aufweist;
eine Trägerstufe (220), die mit wenigstens einem Brückenpaar (240) ausgestattet ist, wobei jede der Brücken eine Verbindungsleitung (265) aufweist, und ein Ende der Verbindungsleitung elektrisch mit dem entsprechenden Verbindungsanschluß verbunden ist;
eine Absorptionsstufe (230), die einen Absorber (295) mit einem oberen (320) und einem unteren (310) Abschnitt und ein Bolometerelement aufweist; und
wenigstens einem Ständerpaar (270), wobei jeder der Ständer zwischen der Absorptionsstufe (230) und der Trägerstufe (220) angeordnet ist und eine elektrische Leitung (272) aufweist, die von einem Isoliermaterial (274) umgeben ist, wobei jedes Ende des Bolometerelementes der Absorptionsstufe elektrisch mit dem entsprechenden Verbindungsanschluß über die jeweilige elektrische Leitung und die jeweilige Verbindungsleitung verbunden ist.

2. Bolometer nach Anspruch 1, bei dem die Absorptionsstufe (230) ferner eine IR-Absorptionsbeschichtung (297) aufweist.

3. Bolometer nach Anspruch 1, bei dem das Bolometerelement aus Metall hergestellt ist.

4. Bolometer nach Anspruch 3, bei dem das Bolometerelement aus Titan (Ti) hergestellt ist.

5. Bolometer nach Anspruch 1, bei dem der obere und der untere Abschnitt aus dem gleichen Material hergestellt sind.

6. Bolometer nach Anspruch 5, bei dem das Material Siliziumoxid (SiO₂) ist.

7. Bolometer nach Anspruch 5, bei dem das Material Siliziumoxi-Nitrid ist (SiOₓN_{y}).

8. Bolometer nach Anspruch 4, bei dem der obere Abschnitt und der untere Abschnitt jeweils aus zwei Schichten bestehen.

9. Bolometer nach Anspruch 8, bei dem der untere Abschnitt einen ersten aus SiOₓN_{y} hergestellten unteren Abschnitt und einen zweiten aus SiO₂ hergestellten unteren Abschnitt aufweist, und der obere Abschnitt einen ersten aus SiO₂ hergestellten oberen Abschnitt und einen zweiten aus SiOₓN_{y} hergestellten oberen Abschnitt aufweist.

10. Bolometer nach Anspruch 1, bei dem die Brücken aus SiO₂ oder SiOₓN_{y} hergestellt sind.

11. Dreistufiges Infrarot-Bolometerelement nach Anspruch 1, bei dem das Bolometerelement von einem aus Siliziumoxid (SiO₂) hergestellten Absorber umgeben ist.

12. Bolometer nach Anspruch 11, bei dem die Brücken aus SiO₂ hergestellt sind.

13. Bolometer nach Anspruch 11, bei dem die Absorptionsschicht ferner eine IR-Absorptionsbeschichtung aufweist.

14. Dreistufiges Infrarot-Bolometer nach Anspruch 1, bei dem das Bolometerelement von einem aus Siliziumoxi-Nitrid (SiOₓN_{y}) hergestellten Absorber umgeben ist.

15. Bolometer nach Anspruch 14, bei dem die Brücken aus SiOₓN_{y} hergestellt sind.

16. Bolometer nach Anspruch 14, bei dem die Absorptionsstufe ferner eine IR-Absorptionsbeschichtung aufweist.

17. Dreistufiges Infrarot-Bolometer nach Anspruch 1, bei dem die Absorptionsstufe einen oberen Absorber, einen unteren Absorber und ein zwischen dem oberen und dem unteren Abschnitt ausgebildetes Bolometerelement aufweist, wobei der untere Abschnitt einen ersten aus SiOₓN_{y} hergestellten unteren Abschnitt und einen zweiten aus SiO₂ hergestellten unteren Abschnitt aufweist, und der obere Abschnitt einen ersten aus SiO₂ hergestellten oberen Abschnitt und einen zweiten aus SiOₓN_{y} hergestellten oberen Abschnitt aufweist.

18. Bolometer nach Anspruch 17, bei dem die Brücken aus SiO₂ oder SiOₓN_{y} hergestellt sind.

19. Bolometer nach Anspruch 17, bei dem die Absorptionsstufe ferner eine IR-Absorptionsbeschichtung aufweist.

## Revendications

1. Bolomètre infrarouge à trois niveaux comprenant :
un niveau de matrice active (210) incluant un substrat (212) et au moins une paire de bornes de raccordement (214) ;
un niveau de support (220) prévu avec au moins une paire de ponts (240), chacun des ponts incluant une ligne de conduction (265), une extrémité de la ligne de conduction étant électriquement raccordée à la borne de raccordement respective ;
un niveau d'absorption (230) incluant un absorbeur (295) ayant une partie supérieure (320) et une partie inférieure (310) et un élément de bolomètre ; et
au moins une paire de montants (270) étant placés entre le niveau d'absorption (230) et le niveau de support (220) et incluant un tube électrique (272) entouré par un matériau isolant (274), chaque extrémité de l'élément de bolomètre du niveau d'absorption étant électriquement raccordée à la borne de raccordement respective à travers le tube électrique respectif et la ligne de conduction respective.

2. Bolomètre selon la revendication 1, dans lequel le niveau d'absorption (230) inclut, en outre, un revêtement d'absorption IR (297).

3. Bolomètre selon la revendication 1, dans lequel l'élément de bolomètre est réalisé en un métal.

4. Bolomètre selon la revendication 3, dans lequel l'élément de bolomètre est réalisé en titane (Ti).

5. Bolomètre selon la revendication 1, dans lequel les parties supérieure et inférieure sont réalisées en un même matériau.

6. Bolomètre selon la revendication 5, dans lequel le matériau est l'oxyde de silicium (SiO₂).

7. Bolomètre selon la revendication 5, dans lequel le matériau est l'oxynitrure de silicium (SiOₓN_{y}).

8. Bolomètre selon la revendication 4, dans lequel la partie supérieure et la partie inférieure se composent de deux couches, respectivement.

9. Bolomètre selon la revendication 8, dans lequel la partie supérieure inclut une première partie inférieure réalisée en SiOₓN_{y} et une seconde partie inférieure réalisée en SiO₂, la partie supérieure inclut une première partie supérieure réalisée en SiO₂ et une seconde partie supérieure réalisée en SiOₓN_{y}.

10. Bolomètre selon la revendication 1, dans lequel les ponts sont réalisés en SiO₂ ou en SiOₓN_{y}.

11. Bolomètre infrarouge à trois niveaux selon la revendication 1, dans lequel l'élément de bolomètre est entouré par un absorbeur réalisé en oxyde de silicium (SiO₂).

12. Bolomètre selon la revendication 11, dans lequel les ponts sont réalisés en SiO₂.

13. Bolomètre selon la revendication 11, dans lequel le niveau d'absorption inclut, en outre, un revêtement d'absorption IR.

14. Bolomètre infrarouge à trois niveaux selon la revendication 1, dans lequel l'élément de bolomètre est entouré par un absorbeur réalisé en oxynitrure de silicium (SiOₓN_{y}).

15. Bolomètre selon la revendication 14, dans lequel les ponts sont réalisés en SiOₓN_{y}.

16. Bolomètre selon la revendication 14, dans lequel le niveau d'absorption inclut, en outre, un revêtement d'absorption IR.

17. Bolomètre infrarouge à trois niveaux selon la revendication 1, dans lequel le niveau d'absorption inclut un absorbeur supérieur, un absorbeur inférieur et un élément de bolomètre formé entre la partie supérieure et la partie inférieure, dans lequel la partie inférieure inclut une première partie inférieure réalisée en SiOₓN_{y} et une seconde partie inférieure réalisée en SiO₂, et la partie supérieure inclut une première partie supérieure réalisée en SiO₂ et une seconde partie supérieure réalisée en SiOₓN_{y}.

18. Bolomètre selon la revendication 17, dans lequel les ponts sont réalisés en SiO₂ ou en SiOₓN_{y}.

19. Bolomètre selon la revendication 17, dans lequel le niveau d'absorption inclut, en outre, un revêtement d'absorption IR.
